# EUROPÄISCHE PATENTSCHRIFT

(11) **EP 3 192 173 B1**
(45) Veröffentlichungstag und Bekanntmachung des Hinweises auf die Patenterteilung: **24.11.2021**
(21) Anmeldenummer: 15781085.4
(22) Anmeldetag: 15.10.2015
(51) Int. Cl.: H03K 17/0814, H02M 1/34, H02M 3/155, H03K 17/16

(54) **HALBBRÜCKE MIT ZWEI HALBLEITERSCHALTERN ZUM BETREIBEN EINER LAST**
HALF BRIDGE HAVING TWO SEMICONDUCTOR SWITCHES FOR OPERATING A LOAD
DEMI-PONT AVEC DEUX RELAIS SEMI-CONDUCTEURS POUR FAIRE FONCTIONNER UNE CHARGE

(30) Priorität: 15.10.2014 DE 102014114954
(43) Veröffentlichungstag der Anmeldung: 19.07.2017
(73) Patentinhaber: Beckhoff Automation GmbH, 33415 Verl (DE)
(72) Erfinder: PRÜSSMEIER, Uwe, 32657 Lemgo (DE)
(74) Vertreter: Patentanwaltskanzlei WILHELM & BECK
(86) Internationale Anmeldenummer: PCT/EP2015/073834
(87) Internationale Veröffentlichungsnummer: WO 2016/059134

(56) Entgegenhaltungen:
- EP-A2- 0 573 836
- US-A- 4 446 513
- US-A1- 2002 135 341
- US-A1- 2011 062 935
- None

## Beschreibung

Die Erfindung betrifft eine Halbbrücke zum Betreiben einer Last mit einer Schalteinrichtung, die einen High-Side-Halbleiterschalter und einen Low-Side-Halbleiterschalter aufweist, die jeweils über einen ihrer Stromanschlüsse seriell miteinander verbunden sind, wobei jedem Halbleiterschalter über seinen Steueranschluss eine Ansteuerung zugeordnet ist, die nach Maßgabe eines Ansteuersignals den jeweiligen Halbleiterschalter leitend oder sperrend schaltet, und wobei die Last zwischen dem High-Side- und dem Low-Side-Halbleiterschalter anschließbar ist sowie einer Entlastungseinrichtung, die mit der Schalteinrichtung verbunden ist, um bei einem Schaltvorgang in der Schalteinrichtung Energie aufzunehmen.

Leistungselektronische Schaltungen weisen oft Halbleiterschalter auf, durch die eine Last mit einer Leistung versorgt wird. In den Halbleiterschaltern können zum Teil hohe Verlustleistungen dissipiert werden, wenn ein hoher Strom durch einen Halbleiterschalter fließt und gleichzeitig eine hohe Spannung über diesem Bauelement anliegt. Solche Verlustleistungen fallen insbesondere bei einem Umschaltvorgang an.

Um eine Beschädigung und/oder eine Beeinträchtigung der Lebenszeit eines Halbleiterschalters durch dissipierte Verlustleistung zu vermeiden, kann eine Schaltfrequenz mit, welcher der Halbleiterschalter umgeschaltet wird, begrenzt werden. Allerdings steht eine solche Begrenzung im Widerspruch zur Forderung nach möglichst hohen Schaltfrequenzen, durch die eine Steuerung einer Last verbessert werden kann.

Eine weitere Möglichkeit, Schaltverluste zu reduzieren, besteht in einer Reduktion der Schaltzeit. Allerdings wirkt sich eine höhere Schaltzeit unter Umständen negative auf das EMV-Verhalten (elektromagnetische Verträglichkeit, EMV) der Schaltung aus, so dass deswegen in der Praxis oft höhere Schaltverluste in Kauf genommen werden.

Des Weiteren können Entlastungsnetzwerke eingesetzt werden, welche dafür sorgen, dass während eines Schaltvorgangs das Produkt aus Spannung und Strom möglichst niedrig ist.

Beispielsweise ist es bekannt, parallel zu einem Transistor einen Kondensator zu schalten, der beim Ausschalten einen Laststrom übernimmt, so dass der Transistor stromlos wird und verlustleistungslos ausgeschaltet werden kann.

Die US 5341004 A schlägt zur Reduktion der Schaltverluste vor, parallel zu einem ersten Halbleiterschalter, einem IGBT (insulated-gate bipolar transistor, IGBT), einen zweiten Halbleiterschalter, ebenfalls einen IGBT, zu verschalten. Der zweite IGBT besitzt eine höhere Sättigungsspannung und eine kürzere Abfallzeit als der erste IGBT und übernimmt somit Strom, wenn der erste IGBT abgeschaltet wird, so dass der Strom nicht mehr über den ersten IGBT fließt und damit eine Verlustleistung begründet.

Die DE 3542751 A1 schlägt zur Reduzierung der Verlustleistung in Beschaltungsnetzwerken für Halbleiterschalter vor, eine sättigbare Stufendrossel in Serie mit dem Halbleiterschalter zu schalten und zu dieser parallel einen ohmschen Widerstand vorzusehen. Damit wird erreicht, dass der beim Einschalten des Halbleiterschalters fließende Stufenstrom in Vorwärtsrichtung geringer ist und dementsprechend geringere Verluste verursacht.

Durch die genannten Lösungen kann zwar eine Verlustleistung unmittelbar im Halbleiterschalter verringert werden, allerdings kann sich eine entsprechende Verlustleistung in der Regel an anderen Teilen der Halbbrücke ergeben, wenn diejenigen Energiespeicher entleert werden, welche zur Verlustleistungsreduktion vorgesehen sind. Dadurch kann auch die Effektivität der Maßnahmen zur Verringerung der Verlustleistung im Halbleiterschalter begrenzt sein, z.B. wenn eine entsprechende Leistung nicht schnell genug kontrolliert abgeführt werden kann.

Aus der DE693 12 585 T2 ist eine gattungsgemäße Halbbrücke mit in Serie geschalteten Halbleiterschalter und einer Entlastungseinrichtung, um bei einem Schaltvorgang in der Halbleiterschaltern Energie aufzunehmen.

Die USA 2011/0062935 A1 offenbart eine Halbbrücke gemäß der Präambel von Anspruch 1.

Aufgabe der vorliegenden Erfindung ist es, einen Halbleiterschalter in einer Halbbrücke effizienter betreiben zu können.

Diese Aufgabe wird durch eine Halbbrücke gemäß Anspruch 1 und eine Schaltungsanordnung gemäß Anspruch 6, die wenigstens eine solche Halbbrücke aufweist, gelöst. Bevorzugte Weiterbildungen sind in den abhängigen Ansprüchen angegeben.

Eine erfindungsgemäße Halbbrücke zum Betreiben einer Last umfasst eine Schalteinrichtung, die einen High-Side-Halbleiterschalter und einen Low-Side-Halbleiterschalter aufweist. Die Halbleiterschalter sind jeweils über einen ihrer Stromanschlüsse seriell miteinander verbunden, wobei jedem Halbleiterschalter über seinen Steueranschluss eine Ansteuerung zugeordnet werden kann, die nach Maßgabe eines Ansteuersignals den jeweiligen Halbleiterschalter leitend oder sperrend schaltet und wobei die Last zwischen dem High-Side- und dem Low-Side-Halbleiterschalter anschließbar ist.
Erfindungsgemäß weist die Halbbrücke eine Entlastungseinrichtung, die mit der Schalteinrichtung verbunden ist, um bei einem Schaltvorgang in der Schalteinrichtung Energie aufzunehmen.

Erfindungsgemäß weist die Halbbrücke eine Energierückgewinnungsschaltung auf, die dazu eingerichtet ist, die von der Entlastungseinrichtung aufgenommene Energie, insbesondere einen Strom, vor einer weiteren Energieaufnahme, insbesondere Stromaufnahme, der Entlastungseinrichtung, bei einem weiteren Schaltvorgang in der Schalteinrichtung, einer Energiespeichereinrichtung zuzuführen.

Durch die Energierückgewinnungsschaltung wird insbesondere vorteilhaft Energie aus der Entlastungseinrichtung vom Halbleiterschalter weggeführt, so dass diese nicht mehr in dem Halbleiterschalter dissipiert werden kann. Zusätzlich oder alternativ kann vorteilhaft durch die Energierückgewinnungsschaltung Energie aus einer Entlastungseinrichtung kontrolliert dissipiert, für spätere Verwendung gespeichert oder in eine Versorgungsenergiequelle zurückgespeist werden. Dadurch wird die der Erfindung zugrunde liegende Aufgabe gelöst und eine effizientere Halbbrücke bereitgestellt.

Erfindungsgemäß ist ein Stromkanal vorgesehen, der die Entlastungseinrichtung mit der Energiespeichereinrichtung verbindet. Die Energiespeichereinrichtung weist eine erste Kapazität auf, welche mit dem Stromkanal verbunden ist. Die erste Kapazität kann insbesondere durch einen Kondensator gebildet sein. Die Kapazität ist insbesondere so mit dem Stromkanal verbunden, dass sie Energie, insbesondere Strom, aus der Entlastungseinrichtung aufnehmen kann. Insbesondere wenn die Entlastungseinrichtung eine Kapazität aufweist, ist die erste Kapazität der Energiespeichereinrichtung so angeordnet, dass sie Strom der Kapazität der Entlastungseinrichtung aufnehmen kann. Insbesondere ist die erste Kapazität der Energiespeichereinrichtung gleich oder größer der Kapazität der Entlastungseinrichtung bemessen, insbesondere um den Faktor 2, vorzugsweise um den Faktor 10 und besonders bevorzugt um den Faktor 100 größer.

Erfindungsgemäß weist die Energiespeichereinrichtung eine zweite Kapazität auf, welche mit dem Stromkanal verbunden und parallel zur ersten Kapazität der Energiespeichereinrichtung geschaltet ist. Die Kapazität ist insbesondere durch einen Kondensator gebildet. Insbesondere ist die Kapazität dazu eingerichtet Energie aus einem, mehreren oder allen Energiespeichern der Entlastungseinrichtung aufzunehmen und insbesondere zwischenzuspeichern. Vorzugsweise ist diese zweite Kapazität größer als die erste Kapazität, insbesondere um den Faktor 10, vorzugsweise um den Faktor 100 und besonders bevorzugt um den Faktor 1000 größer.

Nach einer ersten bevorzugten Weiterbildung weist die Entlastungseinrichtung eine Kapazität auf. Eine Kapazität kann insbesondere durch einen Kondensator gebildet sein. Die Kapazität ist parallel zu dem High-Side-Halbleiterschalter der Schalteinrichtung geschaltet. Insbesondere fällt über der Kapazität im Wesentlichen dieselbe Spannung, wie über dem High-Side-Halbleiterschalter ab. Insbesondere verhindert die Kapazität hochfrequente Spannungsänderungen über dem High-Side-MOSFET (metal-oxide-semiconductor field-effect transistor, MOSFET). Dies gilt insbesondere auch für andere verwendete Halbleiterschalter. Insbesondere ist die Kapazität mit dem Low-Side-Halbleiterschalter und der Last verbunden. Dadurch kann sie vorteilhaft eine Energie aufnehmen, der bei Ausschalten des Low-Side-Halbleiterschalter durch eine induktive Last noch durch den Low-Side-Halbleiterschalter geführt würde.

Weiterhin weist die Entlastungseinrichtung eine Induktivität auf. Eine Induktivität kann insbesondere durch eine Spule gebildet sein. Die Induktivität kann mit einem Versorgungspotentialanschluss verbunden werden oder sein und/oder ist in Serie im Strompfad der Halbleiterschalter geschaltet. Insbesondere ist die Induktivität mit dem Drain-Anschluss des High-Side-Halbleiterschalters verbunden. Zusätzlich oder alternativ kann der andere Anschluss der Induktivität mit dem positiven Versorgungspotentialanschluss einer Energiequelle verbunden sein. Vorteilhaft kann dadurch beim Einschalten des High-Side-Halbleiterschalters ein zu hoher Stromfluss in diesem Halbleiterschalter vermieden werden, da die Spule einen schnellen Stromanstieg vermeidet.

Nach einer weiteren bevorzugten Weiterbildung weist die Energierückgewinnungsschaltung einen Spannungswandler zur Rückspeisung der elektrischen Energie aus der Energiespeichereinrichtung in eine Energieversorgung, insbesondere eine Spannungsversorgung auf, wobei die Energieversorgung insbesondere eine Energie zum Betreiben der Last der Halbbrücke bereitstellt. Der Spannungswandler kann insbesondere ein Gleichspannungs-Gleichspannungs-Wandler (DC/DC-Wandler) sein. Insbesondere kann der Spannungswandler einen Tiefsetzsteller umfassen, der eine Eingangsspannung in eine niedrigere Ausgangsspannung umwandelt. Zusätzlich oder alternativ kann der Spannungswandler einen Hochsetzsteller aufweisen, der eine Eingangsspannung in eine höhere Ausgangsspannung umwandelt. Der Gleichspannungswandler kann insbesondere ein oder mehrere Schaltungsgruppen zur Glättung und/oder Stabilisierung der Ausgangsspannung aufweisen. Insbesondere dient der Gleichspannungswandler dazu Energie aus der Entlastungseinrichtung in einen Zwischenkreis oder einen anderen Speicherort, z.B. einen Akkumulator, zu überführen.

Nach einer weiteren bevorzugten Weiterbildung weist der Stromkanal der Energierückgewinnungsschaltung eine erste eine zweite und eine dritte Diode auf, die seriell miteinander verschaltet sein. Der Stromkanal verbindet die Entlastungseinrichtung mit der Energiespeichereinrichtung. Insbesondere sind eine oder mehrere, vorzugsweise alle, Dioden des Stromkanals, so geschaltet, dass kein Strom durch den Stromkanal zu einem Halbleiterschalter, insbesondere zum High-Side-Halbleiterschalter, geführt werden kann, sondern lediglich von einem Halbleiterschalter, insbesondere dem High-Side-Halbleiterschalter, wegfließen kann. Dadurch kann vorteilhaft insbesondere für alle Phasen der Halbbrücke, insbesondere Einschalten und/oder Ausschalten des High-Side-Halbleiterschalters bzw. Einschalten und/oder Ausschalten des Low-Side-Halbleiterschalters gesichert werden, dass kein Strom, der nicht von einer Versorgungsenergiequelle kommt, durch einen der Halbleiterschalter fließt und insbesondere eine Verlustleistung generiert.

Ferner ist der Stromkanal mit einem Knotenpunkt zwischen der Entlastungseinrichtung und der Schalteinrichtung verbunden. Insbesondere ist der Stromkanal mit dem Knotenpunkt verbunden an dem auch eine Induktivität der Entlastungseinrichtung verbunden ist und/oder an dem auch der High-Side-Halbleiterschalter angeschlossen ist. Dadurch kann vorteilhaft, insbesondere während eines Umschaltvorgangs, ein durch die Spule führender Strom über den Stromkanal abgezweigt werden, bevor er durch den High-Side-Halbleiterschalter fließt und dort als Verlustleistung umgesetzt wird. Zusätzlich oder alternativ kann der Stromkanal mit einer Kapazität verbunden sein, die parallel zu dem High-Side-Halbleiterschalter geschaltet ist. Dadurch kann der Stromkanal vorteilhaft in der Kapazität gespeicherte Energie aufnehmen und diese kann zu der Energiespeichereinrichtung geführt werden. Nach einem oder mehreren, insbesondere allen, Knotenpunkten, an denen ein Strom von der Entlastungseinrichtung und/oder der Energiespeichereinrichtung in den Stromkanal eingeleitet wird, ist eine Diode geschaltet und zwar insbesondere so, dass Strom aus dem Stromkanal nicht in die Schalteinrichtung, insbesondere den High-Side-Halbleiterschalter, nicht in einem vor dem betreffenden Knotenpunkt liegenden Energiespeicher der Entlastungseinrichtung und/oder nicht in einen vor dem betreffenden Knotenpunkt liegenden Energiespeicher der Energiespeichereinrichtung zurückfließen kann.

Weiterhin umfasst der Stromkanal eine Induktivität, welche seriell zur zweiten Kapazität der Energiespeichereinrichtung angeordnet ist. Insbesondere ist die Induktivität durch eine Spule gebildet. Vorzugsweise ist die Induktivität kleiner als eine Induktivität der Entlastungseinrichtung, insbesondere um den Faktor 0.5, bevorzugt um den Faktor 0.25 und besonders bevorzugt um den Faktor 0.1 kleiner. Insbesondere ist die Spule an eine Energieversorgung angeschlossen, und bevorzugt mit einer Diode abgesichert, so dass kein Strom in die Energieversorgung fließen kann. Durch die Induktivität des Stromkanals können vorteilhaft Stromsprünge in der zweiten Kapazität der Energiespeichereinrichtung geglättet werden. Des Weiteren kann die Spule als Saugspule, die in ihr gespeicherte Energie ungestört abbauen, wenn ein Strom aus dem Stromkanal plötzlich versiegt. Dann saugt die Spule aus der Energieversorgung solange Strom, bis sie selbst keine Energie mehr gespeichert hat. Vorzugsweise wird auch diese Energie, insbesondere dieser Strom, in der zweiten Kapazität der Energiespeichereinrichtung aufgenommen. Dadurch werden vorteilhaft Schwingungen innerhalb des Stromkanals vermieden, die insbesondere durch eine plötzliche Stromverringerung und/oder einen plötzlichen Stromanstieg angeregt werden können.

Die einzelnen Weiterbildungen und Ausführungsformen sowie deren einzelne Merkmale können vorteilhaft miteinander kombiniert werden.

Weitere Merkmale, Vorteile und Anwendungsmöglichkeiten der Erfindung ergeben sich aus der nachfolgenden Beschreibung in Zusammenhang mit den Figuren. Es zeigt teilweise schematisiert:
Fig. 1a zeigt eine Schaltung nach einer Ausführungsform der Erfindung.
Fig. 1b zeigt eine Schaltung nach einer weiteren Ausführungsform der Erfindung.
Fig. 2 zeigt Spannungs- und Stromsignale einer Schaltung nach einer Ausführungsform der Erfindung für einen Einschaltvorgang des High-Side-MOSFETs.

Die Aufgabe wird durch eine Halbbrücke zum Betreiben einer Last mit einer Schalteinrichtung, die einen High-Side-Halbleiterschalter und einen Low-Side-Halbleiterschalter aufweist, gelöst.

Eine Halbbrücke im Sinne der vorliegenden Erfindung kann dabei insbesondere einen 2-Quadrantensteller oder einen Synchrongleichrichter umfassen. Eine erfindungsgemäße Halbbrücke kann als Element in einer H-Brücke, in einer B6-Schaltung oder einer entsprechend ähnlichen Schaltungsanordnung verwendet werden. Insbesondere kann eine Halbbrücke einen Tiefsetzsteller und/oder einen Hochsetzsteller aufweisen.

Eine Last im Sinne der vorliegenden Erfindung ist eine elektrische Last, z.B. ein Motor. Insbesondere weist eine Last einen ohmschen Widerstand und/oder eine Induktivität auf. Eine solche Induktivität kann insbesondere eine Spuleninduktivität eines Motors umfassen.

Ein Halbleiterschalter im Sinne der vorliegenden Erfindung kann ein Transistor oder ein transistorähnliches Bauelement sein, insbesondere ein bipolarer Sperrschichttransistor (bipolar junction transistor, BJT), ein Bipolartransistor mit isolierter Gate-Elektrode (insulated-gate bipolar transistor, IGBT), ein Feldeffekttransistor (field-effect transistor, FET) oder ein Metall-Oxid-Halbleiter-Feldeffekttransistor (metal-oxide-semiconductor field-effect transistor, MOSFET) umfassen. Zusätzlich oder alternativ kann ein Halbleiterschalter eine Diode, ein Symistor (Triac) oder ein ähnliches schaltbares Element sein.

Ein Halbleiterschalter weist im Wesentlichen drei Anschlüsse auf. Einen Steueranschluss und zwei Stromanschlüsse. Über einen Steueranschluss kann eine Stromleitfähigkeit des Halbleiterschalters eingestellt werden, insbesondere kann der Halbleiterschalter über den Steueranschluss eingeschaltet, also leitend geschaltet, und ausgeschaltet, also sperrend geschaltet, werden. Über die zwei Stromanschlüsse, kann ein Laststromkreis betrieben werden. Beispielsweise ist bei einem MOSFET der Steueranschluss der Gate-Anschluss. Die Stromanschlüsse sind bei einem MOSFET zum einen der Source-Anschluss und zum anderen der Drain-Anschluss.

Die Halbleiterschalter sind jeweils über einen ihrer Stromanschlüsse seriell miteinander verbunden. Die Halbleiterschalter können seriell zwischen einem ersten, zumindest mittelbar mit dem High-Side-Halbleiterschalter verbundenen, Versorgungspotentialanschluss und einem zweiten, zumindest mittelbar mit dem Low-Side-Halbleiterschalter verbundenen, Versorgungspotentialanschluss verschaltet werden.

Ein Versorgungspotentialanschluss im Sinne der vorliegenden Erfindung ist insbesondere ein Anschluss einer Energiequelle, insbesondere einer Spannungsquelle. Alternativ kann ein Versorgungspotentialanschluss auch ein Anschluss einer Stromquelle sein. Eine Energiequelle kann insbesondere ein Zwischenkreis sein.

Jedem Halbleiterschalter kann über Ihren Steueranschluss eine Ansteuerung zugeordnet werden, die nach Maßgabe eines Ansteuersignals den jeweiligen Halbleiterschalter leitend oder sperrend schalten kann.

Eine Ansteuerung im Sinne der vorliegenden Erfindung ist insbesondere ein Gate-Treiber. Die Ansteuerung wird an das Gate oder einem dem Gate entsprechenden Steueranschluss des Halbleiterschalters angeschlossen. Insbesondere werden beide Transistoren über eine einzige Ansteuerung betrieben. Insbesondere so, dass nicht gleichzeitig beide Halbleiterschalter eingeschaltet sind. Insbesondere ist ein Halbleiterschalter ausgeschaltet, während der andere Halbleiterschalter eingeschaltet ist, dabei wird vorzugsweise erst ein Halbleiterschalter ausgeschaltet und kurz danach der andere Halbleiterschalter eingeschaltet.

Ein Ansteuersignal im Sinne der vorliegenden Erfindung umfasst insbesondere im Wesentlichen konstante Low- und High-Pegel. Dabei bewirkt ein am Steueranschluss anliegender Low-Pegel des Ansteuersignals insbesondere ein Ausschalten des Halbleiterschalters. Zusätzlich oder alternativ bewirkt ein am Steueranschluss anliegender High-Pegel ein Einschalten des Halbleiterschalters. Insbesondere ist ein Ansteuersignal ein pulsweitenmoduliertes Signal.

Die Last ist zwischen dem High-Side- und dem Low-Side-Halbleiterschalter anschließbar. Insbesondere wird die Last zumindest mittelbar zwischen einem Source-Anschluss des High-Side-Halbleiterschalters und einem Drain-Anschluss des Low-Side-Halbleiterschalters angeschlossen.

Die erfindungsgemäße Halbbrücke weist eine Entlastungseinrichtung auf, die mit der Schalteinrichtung verbunden ist, um bei einem Schaltvorgang in der Schalteinrichtung Strom aufzunehmen. Ein solcher Strom kann insbesondere ein Strom sein, der ohne die Entlastungseinrichtung durch einen der beiden Halbleiterschalter fließen würde.

Eine Entlastungseinrichtung im Sinne der vorliegenden Erfindung umfasst insbesondere ein Schaltungsnetzwerk aus passiven Bauteilen.

Ein Schaltvorgang im Sinne der vorliegenden Erfindung ist insbesondere ein Umschalten eines Halbleiterschalters von einem eingeschalteten Zustand in einen ausgeschalteten Zustand. Zusätzlich oder alternativ kann ein Schaltvorgang auch ein Umschalten von einem ausgeschalteten Zustand in einen eingeschalteten Zustand umfassen. Insbesondere umfasst der Schaltvorgang eine Phase in der ein Halbleiterschalter weder als eingeschaltet noch als ausgeschaltet bezeichnet wird. Insbesondere ist eine Einschaltphase eines Halbleiterschalters kürzer als eine Ausschaltphase dieses Halbleiterschalters.

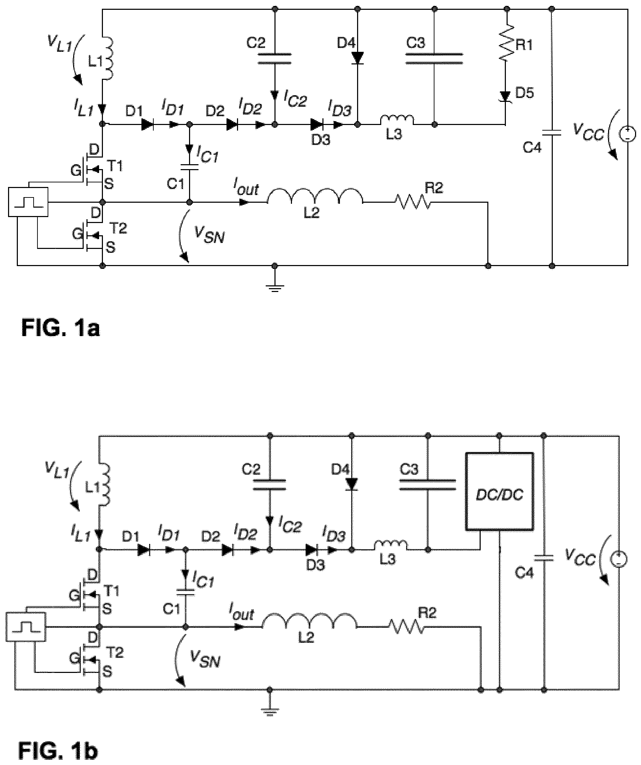

Fig. 1a zeigt eine Schaltungsanordnung mit einer Halbbrücke, die aus zwei MOSFET-Transistoren T1, T2 besteht. Die MOSFETs werden über ihre jeweiligen Gate-Anschlüsse G angesteuert, wobei die Ansteuerung insbesondere ein pulsweitenmoduliertes Signal bereitstellt.

Die MOSFETs T1, T2 sind zwei selbstsperrende n-Kanal-MOSFETs z.B. vom Typ FCB36N60N des Herstellers Fairchild Semiconductor Corp., San Jose, USA. Eine Versorgungsspannung V_{CC} stellt den Strom, der durch die MOSFETs gesteuert werden soll, bereit. Ein erster MOSFET (High-Side-MOSFET) T1 ist mit seinem Drain-Stromanschluss D mit einem Versorgungspotentialanschluss der Versorgungsspannung V_{CC} über eine Induktivität L1 verbunden.

Ein zweiter MOSFET (Low-Side-MOSFET) T2 ist seriell mit dem High-Side-MOSFET T1 so verbunden, dass der Source-Stromanschluss S des High-Side-MOSFETs T1 am Drain-Stromanschluss D des Low-Side-MOSFETs T2 liegt. Der Source-Anschluss des zweiten MOSFETs T2 ist durch Verbindung mit dem zweiten Versorgungspotentialanschluss der Energieversorgung V_{CC} verbunden und liegt auf Erdpotential als Bezugspotential.

Zwischen der Spule L1 und dem High-Side-MOSFET T1 ist ein Stromkanal D1, D2, D3, L3 abgezweigt, welcher über eine Diode D1 so gesichert ist, dass ein Strom über diesen Kanal lediglich vom Drain-Anschluss des High-Side-MOSFET T1 wegfließen kann.

Nach der Diode D1 wird der Stromkanal aufgespalten, in einen ersten Stromzweig, der über einen Kondensator C1 zum Source-Anschluss des High-Side-MOSFET T1 führt, und in einem zweiten Stromzweig, welcher über eine Diode D2 zu einem Kondensator C2 führt, welcher gemeinsam mit der Spule L1 am positiven Potenzial der Versorgungsspannungsquelle V_{CC} liegt.

Der Stromkanal ist Teil der Energierückgewinnungsschaltung. Durch ihn kann die Energie, welche in der Entlastungseinrichtung L1, C1 gespeichert ist, kontrolliert von den MOSFETs entfernt werden.

Zwischen der Diode D2 und dem Kondensator C2 wird ein Stromzweig abgeführt, welcher zu einer Induktivität L3 führt. Diese Induktivität ist mit einem Kondensator C3 verbunden, dessen gegenseitiger Anschluss mit dem positiven Potenzial der Versorgungsspannung V_{CC} gekoppelt ist. Parallel dazu befindet sich ein weiterer Stromzweig mit einem Widerstand R1, welcher über eine Zener-Diode D5 mit der Induktivität L3 verbunden ist.

Die Energiespeicher C2, C3 sind ebenfalls Teil der Energierückgewinnungsschaltung. Durch sie kann die Energie aus dem Stromkanal kontrolliert zwischengespeichert werden.

Eine induktive Last, die durch einen Gleichstrommotor gebildet ist, welcher eine Induktivität L2 und einen ohmschen Widerstand R2 aufweist, liegt eingangsseitig am Knotenpunkt zwischen seriell gekoppelten Stromanschlüssen der MOSFETs T1 und T2 und ist ausgangseitig mit dem Erdpotenzial der Energiequelle V_{CC} verbunden, also auch mit dem Source-Stromanschluss des Low-Side-MOSFETs T2.

Parallel zur Versorgungsspannung und eingangsseitig auf dem gleichen Potenzial wie die Induktivität L1 liegend und ausgangseitig auf Erdpotenzial liegend, befindet sich ein Kondensator C4, der insbesondere zur Glättung der über den MOSFETS T1, T2 anliegenden Spannung verwendet wird. Über der Last fällt die Spannung V_{SN} ab und über der Induktivität L1 fällt die Spannung V_{L1} ab.

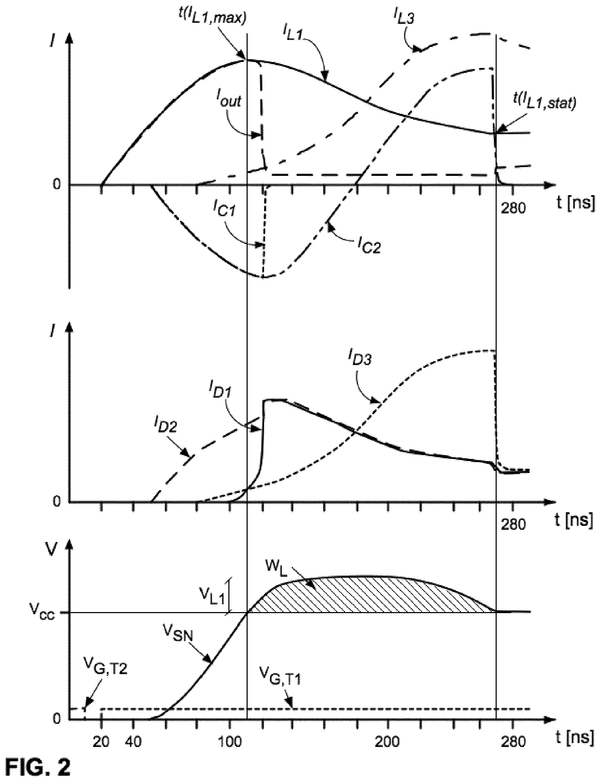

Im Folgenden werden die dynamischen Vorgänge für ein Einschalten des ersten MOSFETs (High-Side-MOSFET) T1 beschrieben. Diese können je nach Verschaltung und Anordnung der passiven und aktiven Elemente bei einer anderen Ausführungsform der Erfindung im Detail von der hier beschriebenen Ausführungsform entsprechend abweichen. In Fig. 2 sind dazu entsprechende Strom- bzw. Spannungssignale über der Zeit t=0 ns bis t=280 ns aufgetragen, welche einen prinzipiellen Verlauf wiedergeben. In der Realität können die Signale insbesondere noch mit Rausch- und Störsignalen beaufschlagt sein. Außerdem können die Signale noch dynamische Vorgänge, insbesondere mit einer kürzeren Einschwingzeit, umfassen.

Durch das pulsweitenmodulierte Steuersignal wird der Gate-Anschluss G des High-Side-MOSFETs T1 so angesteuert, dass dieser stromleitend wird. Zuvor wird der Gate-Anschluss G des Low-Side-MOSFETs T2 vom Gate-Treiber so angesteuert, dass dieser sperrt, in diesem Fall mit einem Nullsignal. Die Spannungssignale vom Gate-Treiber sind im unteren Diagramm der Fig. 2 aufgetragen. Man erkennt, dass der Low-Side-MOSFET T2 bei einer Zeit von 10 ns ausgeschaltet wird, indem die dazugehörige Gate-Spannung V_{G,T2} auf 0 Volt sinkt.

Daneben sieht man, dass die Gate-Spannung V_{G,T1} des ersten MOSFETs T1 bei einer Zeit von 20 ns auf die konstante Referenzspannung ansteigt, welche diesen MOSFET zwischen seinen Stromanschlüssen Drain D und Source S zum Leiten bringt, so dass dieser eingeschaltet wird.

Ein Einschaltvorgang der verwendeten MOSFETs dauert in der Regel länger als ein Ausschaltvorgang. Das Ausschalt-Referenzsignal des Gate-Anschlusses des Low-Side-MOSFET T2 erfolgt 10ns früher als das Einschalt-Referenzsignal des Gate-Anschlusses des High-Side-MOSFETs T1. Durch den endlichen Ausschaltvorgang des Low-Side-MOSFETs T2 und den schnelleren Einschaltvorgang des High-Side-MOSFET T1 sind für eine Zeit beide MOSFETs zumindest teilweise leitend, was zu einem hohen Strom, insbesondere einem Kurzschlussstrom, führen könnte. Die Spule L1 verhindert vorteilhaft einen hohen Strom in den MOSFETs, indem sie den Stromanstieg im Strompfad der MOSFETs begrenzt. Dadurch sind höhere Schaltfrequenzen möglich.

Nach dem Einschalten des High-Side-MOSFET T1 wird ein Strompfad über die Induktivität L1 und dem High-Side-MOSFET T1 zur Last L2, R2 geöffnet. Entsprechend steigt der Strom durch die Induktivität L1 zunächst linear an, bevor er in eine Sättigung übergeht, die in einem Maximum gipfelt. Dies ist im oberen Diagramm von Fig. 2 zu erkennen.

Wegen der Trägheit der Induktivität L1 stellt sich zunächst noch kein Stromfluss durch den High-Side-MOSFET T1 ein. Die Spannung über der Last V_{SN} erhöht sich. Über die Kanaldiode D2 entlädt sich zunächst der Kondensator C1, welcher sich in der zuvor stattgefundenen Ausschaltphase des zweiten Low-Side-MOSFETs T2 aufgeladen hatte. Die im Kondensator C1 gespeicherte Ladung wird über den Strom I_{C1} in einen ersten Zwischenspeicher, der durch den Kondensator C2 dargestellt wird, überführt. Deswegen entlädt sich der Kondensator C1 gleichzeitig, während sich der Kondensator C2 auflädt, wie im oberen Diagramm der Fig. 2 ersichtlich. Der damit verbundene Kanalstrom der Diode D2 ist im mittleren Diagramm von Fig. 2 abgebildet.

Gleichsam mit der Entladung des Kondensators C1 entsteht ein Spannungsabfall V_{SN} über der Last L2, R2, der zunächst linear ansteigt. Durch die Induktivität L1 wird zunächst ein Stromfluss durch die Last begrenzt. Energie, die sonst als Verlustleistung im High-Side-MOSFET T1 dissipiert würde, wird somit zunächst in der Induktivität gespeichert. Der maximale Stromfluss durch die Spule L1 ist bei einer Zeit t(I_{L1,max}) :=110 ns erreicht. Dies ist im oberen Diagramm von Fig. 2 zu erkennen. Im unteren Diagramm von Fig. 2 erkennt man, dass zum Zeitpunkt des maximalen Stromflusses t(I_{L1,max}) durch die Spule L1 die Spannung über der Last V_{SN} genau der Versorgungsspannung V_{CC} entspricht, denn zu diesem Zeitpunkt ist der Kondensator C1 entladen und gibt das Potenzial nach der Diode D1 direkt an die Last weiter.

Ungefähr ab dem Zeitpunkt t=100 ns beginnt ein Strom I_{D1} von der Induktivität L1 durch die Diode D1 des Stromkanals zu fließen. Der Entladevorgang des Kondensators C1 ist zum Zeitpunkt 120 ns abgeschlossen, sodass dann auch der Strom I_{L1} von der Induktivität L1 vom MOSFET T1 zur Diode D1 kommutieren kann.

Der Strom I_{D1} von Diode D1 fließt nun weiter über Diode D2. Das Aufladen des Kondensators C2 führt zu einer Potenzialerhöhung zwischen der Diode D2 und der Diode D3, wodurch die Diode D3 leitend wird. Dadurch fließt der Strom aus der Induktivität L1 über die Dioden D1, D2, D3 in die Induktivität L3. Dies ist an dem steigenden Stromsignal I_{D3} im mittleren Bild der Fig. 2 illustriert.

Der durch die Induktivität L3 tiefpassgefilterte Strom fließt dann in den Kondensator C3. Dieser Kondensator dient als zweiter Speicher des insbesondere von der Induktivität L1 getriebenen Stromes I_{L1}.

Nachdem der Kondensator C1 entladen ist, wird dieser erst wieder aufgeladen, wenn der Low-Side-MOSFET T2 sperrt. Der Kondensator C1 dient somit auch als Kompensator für Spannungssprünge sowohl über der Last als auch über dem Low-Side-MOSFET T2.

Der Stromfluss von der Induktivität L1 durch den Stromkanal über die Diode D1 bzw. über die Diode D2 zur Induktivität L3 zeigt einen Spannungsabfall V_{SN} über der Last, welcher die Versorgungsspannung V_{CC} übersteigt. Diese Spannungsüberhöhung wird durch die Energie begründet, welche in der Induktivität L1 gespeichert ist, nachdem diese sich entsprechend aufgeladen hat. Dies ist im unteren Diagramm von Fig. 2 durch den schraffierten Bereich W_{L} markiert.

Da die Induktivität L1 als Trägheit bezüglich des von ihr getriebenen Stromes wirkt, fällt zwar über der Last eine höhere Spannung ab als durch die Versorgungsspannung bereitgestellt wird, der durch diese Überhöhung begründete Strom fließt allerdings weder durch den leitenden High-Side-MOSFET T1 noch durch den sperrenden Low-Side-MOSFET T2 und begründet damit keine in diesen Bauteilen dissipierte Verlustleistung.

Die Verlustleistung wird vielmehr über den Stromkanal, der durch die Dioden D1, D2, D3 nur in eine Richtung durchgängig ist, in den Hauptspeicher C3 der Energiespeichereinrichtung abgeführt. Von diesem durch den Kondensator C3 begründeten Hauptspeicher kann der Strom in ein Widerstandsnetzwerk R1 abgeführt werden, um diesen dort kontrolliert zu dissipieren, ohne die MOSFETs zu belasten. Im vorliegenden Fall beträgt der Ballastwiderstand R1 mit 10 Ohm dimensioniert.

In der in Fig. 1b dargestellten alternativen Ausführungsform wird die von den MOSFETs ferngehaltene Verlustleistung in die Energieversorgung zurückgespeist. Ein dazu erforderliches Energierückgewinnungsnetzwerk kann insbesondere einen Gleichstrom-Gleichstrom-Wandler DC/DC aufweisen, um die rückgewinnbare Energie auf eine Spannung der Energieversorgung, z.B. auf eine Spannung des Zwischenkreises zu transformieren. Zusätzlich oder alternativ kann ein Energierückgewinnungsnetzwerk auch einen Tiefsetzsteller und/oder einen Hochsetzsteller umfassen. Damit wird vorteilhaft ein großer Teil der Verlustleistung nicht nur von den MOSFETs ferngehalten, sondern vielmehr wird dieser Teil energieneutral wiederverwertet.

Nach ca. 270 ns wird der Stromfluss von der Diode D3 sprunghaft verringert, da der Kondensator C2, also der Zwischenspeicher, vollständig entladen ist. Der Strom durch die Diode D3 entspricht nunmehr dem Strom I_{D1} bzw. I_{D2}, welcher nun langsam vom High-Side-MOSFET T1 übernommen wird. Zu diesem Zeitpunkt ist der Energiespeicher der Induktivität L1 vollständig entleert und die Spannung V_{SN} über der Last auf einem statischen Wert angelangt. Der Strom durch die Induktivität L3 kommutiert dann von der Diode D3 zur Diode D4, da die Induktivität L3 ihren Stromfluss aufrechterhalten möchte. Die Induktivität L3 wirkt dann als "Saugdrossel" und zieht Strom über die Diode D4 solange, bis die in ihr gespeicherte Energie aufgebraucht ist. Auch dadurch werden abrupte Stromänderungen im Strompfad zum Kondensator C3 vermieden.

In einer nicht dargestellten Ausführungsform können Schwingungen, welche bei einer Kommutierung des Stroms zwischen D3 und D4 generiert werden, durch einen RC-Tiefpass gedämpft werden, welcher insbesondere parallel zur Diode D4 angeordnet werden kann.

Je nach Kapazität des Kondensators C2 liegt eine annähernd konstante Spannung am Knotenpunkt zwischen der Induktivität L3 und dem Speicherkondensator C3.

Die Kapazität des Kondensators C1 ist dabei mit 680 pF kleiner als die Kapazität des Kondensators C2, die 4 nF beträgt. Dies liegt daran, dass der Kondensator C1 zur Vermeidung von Spannungssprüngen über den MOSFETs verwendet wird, wobei der Kondensator C2 als Zwischenspeicher insbesondere für die vom Kondensator C1 stammende Ladung vorgesehen ist. Der Kondensator C3 ist mit 2000 nF als großer Zwischenspeicher dimensioniert, um sowohl die Ladung vom Kondensator C1 über den Kondensator C2 zu erhalten als auch die von der Spule L1 gespeicherte Energie, welche einen Großteil der ansonsten im MOSFET T1 dissipierten Energie darstellt. Der Glättungskondensator C4 ist mit 50µF dimensioniert.

Die Induktivität der Spule L1 ist mit 2,7µH größer bemessen als die Induktivität der Spule L3, die 1µH bemisst. Dies liegt daran, dass die Spule L3 als Energiespeicher ausgelegt ist, für die ansonsten als Verlustleistung im High-Side-MOSFET T1 während eines Umschaltvorgangs auflaufende Energie. Die Induktivität L2 der Last kann wesentlich größer sein und beträgt im vorliegenden Fall ca. 100µH.

Zusammenfassend erfolgt die Verlustleistungsreduzierung zum einen durch einen parallel geschalteten Kondensator C1, der insbesondere Spannungssprünge am High-Side-MOSFET T1 verhindert und damit ein Produkt aus Spannung und Strom minimiert, weil die über dem Transistor im Strompfad abfallende Spannung annähernd 0V ist. Der Kondensator C1 verhindert für die Transistoren einen schnellen Spannungsanstieg, indem er Stromänderungen "oben aufnimmt" und so eine relativ langsame Spannungsänderung, seine Ladekurve, zur Folge hat. Der Kondensator C1 nimmt dabei elektrische Energie auf, die Transistoren werden für ihre Schaltzeit entlastet und dissipieren kaum Verlustleistung. Diese Energie befindet sich stattdessen auf dem Kondensator C1.

Für den nächsten Schaltvorgang muss die Energie vom Kondensator C1 entfernt werden, damit er erneut in oben beschriebener Weise operieren kann. Zum Abtransport dieser Energie dient der Zwischenspeicherkondensator C2 und der Stromkanal durch die Dioden D2, D3 sowie der Spule L3 hin zum Hauptspeicherkondensator C3.

Zum anderen verhindert die Induktivität L1, die in Serie mit den MOSFETs geschaltet ist, einen plötzlichen Stromanstieg. So kann das Umschalten des oben genannten Kondensators ohne hohe Ströme stattfinden, welche zu einer hohen Verlustleistung führen und eventuell den Kondensator sogar zerstören können. Außerdem wird durch die Spule L1 beim kurzzeitigen Einschalten beider Transistoren, welches eigentlich zu vermeiden ist, ein sehr hoher Querstrom bzw. ein Kurzschluss unterbunden. Nachdem die Spulen zum Zeitpunkt des Schaltens der Transistoren eine Stromerhöhung erfahren haben, muss ihr Strom wieder auf den Wert 0 Ampere oder auf die Höhe des Ausgangsstromes I_{Out} der Schaltung reduziert werden. Diese Stromänderung/-reduzierung kann erreicht werden, indem Energie abgeführt wird. Diese Energieabführung erfolgt über den Stromkanal, welcher durch die Dioden D1, D2 zu dem Zwischenspeicher C2 führt bzw. weiter über die Diode D3 und die Induktivität L3 zu dem Hauptspeicherkondensator C3.

Vom Hauptspeicherkondensator C3 kann die von den Transistoren ferngehaltene Verlustleistung beispielsweise kontrolliert in einem Ballastwiderstandsnetzwerk dissipiert werden oder über eine Rückgewinnungsschaltung, insbesondere einen DC/DC-Wandler, wieder in die Energieversorgung eingespeist werden.

## Patentansprüche

1. Halbbrücke (1) zum Betreiben einer Last (L2, R2) mit
einer Schalteinrichtung, die einen High-Side-Halbleiterschalter (T1) und einen Low-Side-Halbleiterschalter (T2) aufweist, die jeweils über einen ihrer Stromanschlüsse (S, D) seriell miteinander verbunden sind, wobei jedem Halbleiterschalter über einen Steueranschluss (G) eine Ansteuerung zugeordnet werden kann, die nach Maßgabe eines Ansteuersignals den jeweiligen Halbleiterschalter leitend oder sperrend schaltet und wobei die Last (L2, R2) zwischen dem High-Side- und dem Low-Side-Halbleiterschalter anschließbar ist;
einer Entlastungseinrichtung (L1, C1), die mit der Schalteinrichtung verbunden ist, um bei einem Schaltvorgang in der Schalteinrichtung Energie aufzunehmen; einer Energiespeichereinrichtung, die eine erste Kapazität (C2) umfasst; und
einer Energierückgewinnungsschaltung (D1, D2, D3, L3), die dazu eingerichtet ist, die von der Entlastungseinrichtung (L1, C1) aufgenommene Energie vor einer weiteren Energieaufnahme der Entlastungseinrichtung (L1, C1) bei einem weiteren Schaltvorgang in der Schalteinrichtung der Energiespeichereinrichtung zuzuführen, wobei die Energierückgewinnungsschaltung (D1, D2, D3, L3) einen Stromkanal aufweist, der die Entlastungseinrichtung (L1, C1) mit der ersten Kapazität (C2) der Energiespeichereinrichtung verbindet,
**dadurch gekennzeichnet, dass**
die Energiespeichereinrichtung eine zweite Kapazität (C3), welche mit dem Stromkanal (D1, D2, D3, L3) verbunden, aufweist, wobei die erste Kapazität (C2) und die zweite Kapazität jeweils vom Stromkanal abzweigen, so dass die zweite Kapazität (C3) parallel zur ersten Kapazität (C2) angeordnet ist, und wobei die zweite Kapazität (C3) ausgelegt ist, die Energie aus allen Energiespeichern der Entlastungseinrichtung (L1, C1) und der ersten Kapazität (C2) aufzunehmen,
wobei nach einem oder mehreren Knotenpunkten, an denen ein Strom von der Entlastungseinrichtung (L1, C1) und/oder der Energiespeichereinrichtung in den Stromkanal eingeleitet wird, eine Diode geschaltet ist und zwar so, dass Strom aus dem Stromkanal nicht in die Schalteinrichtung, nicht in einem vor dem betreffenden Knotenpunkt liegenden Energiespeicher der Entlastungseinrichtung und/oder nicht in einen vor dem betreffenden Knotenpunkt liegenden Energiespeicher der Energiespeichereinrichtung zurückfließen kann.

2. Halbbrücke nach Anspruch 1, **dadurch gekennzeichnet, dass** die Entlastungseinrichtung (L1, C1) eine Kapazität (C1), die über eine erste Diode (D1) des Stromkanals (D1, D2, D3, L3) parallel zu dem High-Side-Halbleiterschalter (T1) der Schalteinrichtung geschaltet ist, und eine Induktivität (L1), die in Serie mit den Halbleiterschaltern (T1, T2) geschaltet ist, aufweist.

3. Halbbrücke (1) nach Anspruch 2, **dadurch gekennzeichnet, dass** der Stromkanal (D1, D2, D3, L3) zwischen der Induktivität (L1) der Entlastungseinrichtung (L1, C1) und den Halbleiterschaltern (T1, T2) abgezweigt und eine zweite und dritte Diode (D2, D3) und eine Induktivität (L3) umfasst, wobei die erste Diode (D1), die zweite Diode (D2), die dritte Diode (D3) und die Induktivität (L3) des Stromkanals seriell miteinander verschaltet sind, wobei der Stromkanal nach der erste Diode (D1) sich aufspaltet in einen ersten Stromzweig mit der Kapazität (C1) der Entlastungseinrichtung (L1, C1) und in einen zweiten Stromzweig, welcher über die zweiten Diode (D2) zu der ersten Kapazität (C2) der Energiespeichereinrichtung (C2, C3) führt, wobei von dem zweiten Strompfad nach der zweiten Diode (D2) ein dritter Strompfad abzweigt, welcher über die dritte Diode (D3) und die Induktivität (L3) des Stromkanals zu der zweite Kapazität (C3) der Energiespeichereinrichtung (C2, C3) führt.

4. Halbbrücke (1) nach Anspruch 3, **dadurch gekennzeichnet, dass** eine weitere Diode (D4) in einem weiteren Stromzweig vorgesehen ist, wobei der weitere Stromzweig mit der weitere Diode (D4) zwischen der dritten Diode (D3) und der Induktivität (L3) des Stromkanals vom Stromkanal abgezweigt, so dass die weitere Diode (D4) parallel zur dritten Diode (D3) des Stromkanals (D1, D2, D3, L3) angeordnet ist.

5. Halbbrücke (1) nach einem der vorherigen Ansprüche, **dadurch gekennzeichnet, dass** die Energierückgewinnungsschaltung (D1, D2, D3, L3) einen Spannungswandler (DC/DC) zur Rückspeisung der elektrischen Energie aus der Energiespeichereinrichtung (C2, C3) in eine Energieversorgung (V_{cc}) der Halbbrücke aufweist.

6. Schaltungsanordnung mit wenigstens einer Halbbrücke nach einem der vorhergehenden Ansprüche, wobei die Schaltungsanordnung insbesondere eine Vollbrücke, eine H-Brücke oder eine B6-Schaltung aufweist.

## Claims

1. Half bridge (1) for operating a load (L2, R2) comprising
a switching device comprising a high-side semiconductor switch (T1) and a low-side semiconductor switch (T2), which are connected to one another in series in each case via one of their current terminals (S, D), wherein each semiconductor switch may be assigned, via a control terminal (G), a driving system which switches the respective semiconductor switch on or off according to a drive signal, and wherein the load (L2, R2) is connectable between the high-side and the low-side semiconductor switches;
a load relief device (L1, C1) connected to the switching device in order to collect energy during a switching process in the switching device;
an energy storage device comprising a first capacitance (C2); and
an energy recovery circuit (D1, D2, D3, L3) configured to feed the energy collected by the load relief device (L1, C1) to the energy storage device before a further energy collection of the load relief device (L1, C1) during a further switching process in the switching device, wherein the energy recovery circuit (D1, D2, D3, L3) comprises a current channel which connects the load relief device (L1, C1) to the first capacitance (C2) of the energy storage device,
**characterized in that**
the energy storage device comprises a second capacitance (C3), which is connected to the current channel (D1, D2, D3, L3), wherein the first capacitance (C2) and the second capacitance each branch off from the current channel such that the second capacitance (C3) is arranged in parallel with the first capacitance (C2), and wherein the second capacitance (C3) is designed to collect the energy from all energy stores of the load relief device (L1, C1) and the first capacitance (C2),
wherein a diode is connected downstream of one or a plurality of nodes at which a current from the load relief device (L1, C1) and/or the energy storage device is introduced into the current channel, specifically such that current from the current channel cannot flow back into the switching device, cannot flow back into an energy store of the load relief device that is located upstream of the relevant node, and/or cannot flow back into an energy store of the energy storage device that is located upstream of the relevant node.

2. Half bridge according to Claim 1, **characterized in that** the load relief device (L1, C1) comprises a capacitance (C1) connected in parallel with the high-side semiconductor switch (T1) of the switching device via a first diode (D1) of the current channel (D1, D2, D3, L3), and an inductance (L1) connected in series with the semiconductor switches (T1, T2).

3. Half bridge (1) according to Claim 2, **characterized in that** the current channel (D1, D2, D3, L3) branches off between the inductance (L1) of the load relief device (L1, C1) and the semiconductor switches (T1, T2) and comprises a second and third diode (D2, D3) and an inductance (L3), wherein the first diode (D1), the second diode (D2), the third diode (D3) and the inductance (L3) of the current channel are interconnected in series with one another, wherein the current channel downstream of the first diode (D1) splits into a first current branch comprising the capacitance (C1) of the load relief device (L1, C1) and into a second current branch, which leads via the second diode (D2) to the first capacitance (C2) of the energy storage device (C2, C3), wherein a third current path branches off from the second current path downstream of the second diode (D2), said third current path leading via the third diode (D3) and the inductance (L3) of the current channel to the second capacitance (C3) of the energy storage device (C2, C3).

4. Half bridge (1) according to Claim 3, **characterized in that** a further diode (D4) is provided in a further current branch, wherein the further current branch with the further diode (D4) branches off from the current channel between the third diode (D3) and the inductance (L3) of the current channel such that the further diode (D4) is arranged in parallel with the third diode (D3) of the current channel (D1, D2, D3, L3).

5. Half bridge (1) according to any one of the preceding claims, **characterized in that** the energy recovery circuit (D1, D2, D3, L3) comprises a voltage converter (DC/DC) for feeding back the electrical energy from the energy storage device (C2, C3) into an energy supply (V_{cc}) of the half bridge.

6. Circuit arrangement comprising at least one half bridge according to any one of the preceding claims, wherein the circuit arrangement comprises in particular a full bridge, an H-bridge or a B6 circuit.

## Revendications

1. Demi-pont (1) permettant de faire fonctionner une charge (L2, R2), comprenant un dispositif de commutation qui présente un commutateur à semi-conducteur côté haut (T1) et un commutateur à semi-conducteur côté bas (T2) qui sont respectivement connectés en série par l'intermédiaire d'une de leurs bornes de courant (S, D), dans lequel chaque commutateur à semi-conducteur peut être associé, par l'intermédiaire d'une borne de commande (G), à un dispositif de pilotage qui met le commutateur à semi-conducteur respectif à l'état passant ou à l'état bloquant conformément à un signal de pilotage, et la charge (L2, R2) peut être connectée entre le commutateur à semi-conducteur côté haut et le commutateur à semi-conducteur côté bas ;
un dispositif de décharge (L1, C1) qui est relié au dispositif de commutation afin d'absorber de l'énergie lors d'une opération de commutation dans le dispositif de commutation ;
un dispositif de stockage d'énergie qui comprend une première capacité (C2) ; et
un circuit de récupération d'énergie (D1, D2, D3, L3) qui est aménagé pour amener au dispositif de stockage d'énergie l'énergie absorbée par le dispositif de décharge (L1, C1) avant toute absorption d'énergie supplémentaire du dispositif de décharge (L1, C1) lors d'une opération de commutation supplémentaire dans le dispositif de commutation, le circuit de récupération d'énergie (D1, D2, D3, L3) présentant un canal de courant qui relie le dispositif de décharge (L1, C1) à la première capacité (C2) du dispositif de stockage d'énergie,
**caractérisé en ce que** le dispositif de stockage d'énergie présente une deuxième capacité (C3) qui est reliée au canal de courant (D1, D2, D3, L3), la première capacité (C2) et la deuxième capacité bifurquant respectivement à partir du canal de courant de sorte que la deuxième capacité (C3) est disposée en parallèle à la première capacité (C2), et la deuxième capacité (C3) étant conçue pour absorber l'énergie de tous les accumulateurs d'énergie du dispositif de décharge (L1, C1) et de la première capacité (C2),
dans lequel une diode est connectée après un ou plusieurs nœuds auxquels un courant du dispositif de décharge (L1, C1) et/ou du dispositif de stockage d'énergie est injecté dans le canal de courant, notamment de telle sorte que le courant provenant du canal de courant ne peut pas refluer dans le dispositif de commutation, ni dans un accumulateur d'énergie, situé avant le nœud en question, du dispositif de décharge et/ou ni dans un accumulateur d'énergie, situé avant le nœud en question, du dispositif de stockage d'énergie.

2. Demi-pont selon la revendication 1, **caractérisé en ce que** le dispositif de décharge (L1, C1) présente une capacité (C1) qui est connectée par l'intermédiaire d'une première diode (D1) du canal de courant (D1, D2, D3, L3) en parallèle avec le commutateur à semi-conducteur côté haut (T1) du dispositif de commutation, et une inductance (L1) qui est connectée en série avec les commutateurs à semi-conducteur (T1, T2).

3. Demi-pont (1) selon la revendication 2, **caractérisé en ce que** le canal de courant (D1, D2, D3, L3) bifurque entre l'inductance (L1) du dispositif de décharge (L1, C1) et les commutateurs à semi-conducteur (T1, T2) et comprend une deuxième et une troisième diode (D2, D3) et une inductance (L3), la première diode (D1), la deuxième diode (D2), la troisième diode (D3) et l'inductance (L3) du canal de courant étant interconnectées en série, le canal de courant se séparant après la première diode (D1) en une première branche de courant avec la capacité (C1) du dispositif de décharge (L1, C1) et en une deuxième branche de courant qui conduit à la première capacité (C2) du dispositif de stockage d'énergie (C2, C3) en passant par la deuxième diode (D2), un troisième trajet de courant bifurquant du deuxième trajet de courant après la deuxième diode (D2) et conduisant par l'intermédiaire de la troisième diode (D3) et de l'inductance (L3) du canal de courant à la deuxième capacité (C3) du dispositif de stockage d'énergie (C2, C3).

4. Demi-pont (1) selon la revendication 3, **caractérisé en ce qu'**une diode supplémentaire (D4) est prévue dans une branche de courant supplémentaire, la branche de courant supplémentaire avec la diode supplémentaire (D4) entre la troisième diode (D3) et l'inductance (L3) du canal de courant bifurquant du canal de courant de sorte que la diode supplémentaire (D4) est disposée en parallèle avec la troisième diode (D3) du canal de courant (D1, D2, D3, L3).

5. Demi-pont (1) selon l'une quelconque des revendications précédentes, **caractérisé en ce que** le circuit de récupération d'énergie (D1, D2, D3, L3) présente un convertisseur de tension (CC/CC) pour la réinjection de l'énergie électrique du dispositif de stockage d'énergie (C2, C3) dans une alimentation en énergie (V_{cc}) du demi-pont.

6. Agencement de circuit, comprenant au moins un demi-pont selon l'une quelconque des revendications précédentes, l'agencement de circuit présentant en particulier un pont intégral, un pont en H ou un circuit B6.
